# EUROPÄISCHE PATENTSCHRIFT

(11) **EP 2 414 725 B1**
(45) Veröffentlichungstag und Bekanntmachung des Hinweises auf die Patenterteilung: **22.03.2017**
(21) Anmeldenummer: 10715747.1
(22) Anmeldetag: 26.03.2010
(51) Int. Cl.: H01L 25/075, H05K 1/00, F21K 9/00, F21Y 115/10

(54) **LED-LICHTQUELLE MIT EINER VIELZAHL VON LED-CHIPS UND LED-CHIP ZUR VERWENDUNG IN SELBIGER**
LED LIGHT SOURCE COMPRISING A PLURALITY OF LED CHIPS AND LED CHIP FOR USE IN THE SAME
SOURCE DE LUMIÈRE À LED COMPORTANT UNE PLURALITÉ DE PUCES À LED ET PUCE À LED DESTINÉE À UNE UTILISATION DANS UNE TELLE SOURCE DE LUMIÈRE

(30) Priorität: 31.03.2009 DE 102009015224
(43) Veröffentlichungstag der Anmeldung: 08.02.2012
(73) Patentinhaber: Siemens Aktiengesellschaft, 80333 München (DE)
(72) Erfinder: GERHARD, Detlef, 81829 München (DE)
(86) Internationale Anmeldenummer: PCT/EP2010/053993
(87) Internationale Veröffentlichungsnummer: WO 2010/112419

(56) Entgegenhaltungen:
- EP-A1- 1 189 283
- EP-A1- 1 901 406
- DE-A1-102007 041 896
- JP-A- 5 042 718
- JP-A- 2000 244 020
- US-A- 5 997 152
- US-A1- 2005 133 800

## Beschreibung

Die Erfindung betrifft eine LED-Lichtquelle, aufweisend eine Vielzahl von LED-Chips, die auf einem Substrat fixiert und elektrisch kontaktiert sind. Weiterhin betrifft die Erfindung einen LED-Chip mit einer Oberseite und einer Unterseite, die beide Kontaktbereiche zur elektrischen Kontaktierung aufweisen.

Eine LED-Lichtquelle der eingangs genannten Art ist beispielsweise aus der US 2007/007558 A1 bekannt. Bei dieser LED-Lichtquelle kommt ein Substrat zum Einsatz, auf dem in regelmäßigen Abständen einzelne LED-Chips kontaktiert werden. Diese werden mit ihrer Unterseite auf dem Substrat fixiert, wobei ihre Oberseite als Abstrahlfläche für das zu emittierende Licht verwendet werden. Mittels der LED-Lichtquelle kann ein Leuchtmittel geschaffen werden, welches trotz der geringen Lichtleistung einzelner LEDs eine ausreichende Lichtleistung beispielsweise für eine Beleuchtung von Probekörpern zu Untersuchtungszwecken liefert. Als LED-Chips können auch an sich bekannte Bausteine verwendet werden, die an der Oberseite und an der Unterseite jeweils mit einem elektrischen Leiter kontaktiert werden können. Diese Kontaktierung dient als Energieversorgung, um die LED-Chips zum Leuchten zu bringen.

Gemäß der US 5,997,152 ist eine Lichtquelle, bestehend aus einem Substrat und LED-Chips beschrieben, bei dem das Substrat zur Montage der LED-Chips zwei Montageniveaus zur Verfügung stellt. Daher können die LED-Chips in zwei Ebenen derart montiert werden, dass deren Ränder sich überlappen. Außerdem werden in der EP 1 901 406 A1 LED-Chips beschrieben, die an den Seitenkanten elektrisch kontaktiert werden. Zwischen den elektrischen Kontakten ist daher eine Isolation der Seitenkanten der LED-Chips notwendig.

Die Aufgabe der Erfindung besteht darin, eine LED-Lichtquelle der eingangs genannten Art bzw. LED-Chips zur Verwendung in dieser Lichtquelle anzugeben, mit der eine vergleichsweise homogene Beleuchtung von Objekten mit vergleichsweise hoher Lichtintensität und hoher Zuverlässigkeit im Dauerbetrieb ermöglicht wird.

Diese Aufgabe wird mit der eingangs genannten LED-Lichtquelle erfindungsgemäß dadurch gelöst, dass die LED-Chips überlappend auf dem Substrat fixiert sind, wobei jeweils sich an Oberseite und Unterseite überlappende LED-Chips in einem so gebildeten Überlappungsbereich unter Ausbildung einer Reihenschaltung elektrisch leitend miteinander verbunden sind. Hierfür ist es notwendig, dass jeweils eine elektrische Kontaktierung auf der Oberseite der LED-Chips und eine elektrische Kontaktierung auf der Unterseite der LED-Chips erfolgt. Die Oberseite ist ansonsten dadurch definiert, dass sie die Abstrahlfläche der LED-Chips bildet, während diese mit ihrer Unterseite auf dem Substrat fixiert sind. Durch überlappende Anordnung mehrerer LED-Chips entsteht eine dachziegelähnliche Struktur, wobei die LED-Chips jeweils eine Kette ausbilden, und hierdurch die elektrische Reihenschaltung derselben verwirklicht wird.

Erfindungsgemäß ist außerdem vorgesehen, dass das Substrat eine gestufte Montageseite für die LED-Chips aufweist, wobei jeweils benachbarte LED-Chips mit den jeweils außerhalb der Überlappungsbereiche liegenden Teilen ihrer Unterseiten auf aufeinanderfolgenden Stufen aufliegen. Hierdurch ist es vorteilhaft möglich, die LED-Chips mit einer größtmöglichen Fläche mit dem Substrat mechanisch zu kontaktieren. Hierdurch wird vorteilhaft die direkte Wärmeleitung aus den LED-Chips in das Substrat gefördert. Wenn dieses eine genügende Wärmekapazität und Wärmeleitfähigkeit aufweist, um die in den LED-Chips entstehende Wärme abzuführen, kann hierdurch vorteilhaft die Bauteilzuverlässigkeit der LED-Lichtquelle auch im Dauerbetrieb gewährleistet sein.

Die Stufenhöhe der gestuften Montageseite muss so gewählt sein, dass sich benachbarte Chips miteinander verbinden lassen. Hierbei ist auch die Dicke der erforderlichen Kontaktierung zu berücksichtigen. Diese kann beispielsweise aus einem Lotwerkstoff bestehen, der an der Oberseite oder der Unterseite der LED-Chips vor der Montage bereits angebracht wurde. Für diesen Lotwerkstoff muss ein Spalt zwischen benachbarten LED-Chips verbleiben, der über die Höhe der Stufen auf dem Substrat eingestellt werden kann. Mit anderen Worten müssen die Stufen in diesem Fall etwas höher als die Höhe der LED-Chips sein. Die minimal notwendige Stufenhöhe ist damit durch die Chiphöhe der LED-Chips festgelegt und gilt für die Bauform der LED-Lichtquelle, bei denen kein zusätzlicher Bauraum für die elektrische Kontaktierung benachbarter LED-Chips vorgesehen werden muss.

Durch die Überlappung der LED-Chips ist es möglich, eine elektrische Kontaktierung benachbarter LED-Chips ohne die Ausbildung von Zwischenräumen zu verwirklichen. Gewöhnliche Kontaktierungen, die bevorzugt mittels Bonddrähten erfolgen, erfordern nämlich zwischen benachbarten LED-Chips jeweils eine Leiterbahn auf dem Substrat, wodurch die Packungsdichte der LED-Chips auf dem Substrat nicht unbegrenzt vergrößert werden kann. Hier setzt die vorliegende Erfindung an, indem durch Überlappung der LED-Chips Zwischenräume zwischen benachbarten LED-Chips einer Kette nicht mehr erforderlich sind, so dass im abgestrahlten Licht weniger Inhomogenitäten auftreten. Gleichzeitig lässt sich durch die genannte Vergrößerung der Packungsdichte auch die mittlere abgestrahlte Lichtmenge pro Flächeneinheit vergrößern, so dass bei gegebener Abstrahlleistung der LED-Chips und vorgegebener Fläche des Substrates vorteilhaft ein Maximum an Lichtausbeute erreicht werden kann.

Zu erwähnen ist weiterhin, dass auch der Abstand benachbarter LED-Chips quer zur Ausrichtung der sich überlappenden LED-Chipreihen vorteilhaft auf ein Minimum reduziert werden kann. Auch hier muss kein Platz für eine Kontaktierung der LED-Chips gelassen werden. Der notwendige Spalt zwischen den beiden LED-Chips ist vielmehr dem Erfordernis einer elektrischen Isolation zwischen benachbarten LED-Chipreihen geschuldet. Hierbei können jedoch vergleichsweise geringe Zwischenräume realisiert werden, so dass auch unter Berücksichtigung dieses Gestaltungserfordernisses die erfindungsgemäß gewünschte hohe unhomogene Lichtausbeute gewährleistet werden kann. So entsteht eine dicht gepackte Anordnung der LED-Chips auf dem Substrat, wobei die LED-Chips in parallel verlaufenden Reihen angeordnet sind und jeweils benachbarte LED-Chips sich in den Reihen überlappen.

Gemäß einer anderen Ausgestaltung der Erfindung ist vorgesehen, dass sich jeweils benachbarte LED-Chips in den Reihen mit einem Versatz senkrecht zur Ausbildung der Reihe überlappen. Hierdurch lässt sich eine Richtungsänderung in der Ausrichtung der Reihe von LED-Chips erreichen. Auch ist es möglich, ähnlich den Dachziegeln eines Daches, dass eine elektrische Vernetzung von LED-Chips benachbarter Reihen erfolgt, indem jeweils ein LED-Chip mit zwei LED-Chips aus unterschiedlichen Reihen gleichzeitig kontaktiert ist. Hierdurch lässt sich vorteilhaft die Zuverlässigkeit der LED-Lichtquelle erhöhen, da für den Fall eines Ausfalls einer elektrischen Verbindung zwischen zwei LED-Chips nicht eine komplette Reihe von LED-Chips ausfällt, sondern der Strom über benachbarte LED-Chipreihen umgeleitet werden kann.

Eine wieder andere Ausgestaltung der Erfindung sieht vor, dass die LED-Chips gekippt mit einer dem Überlappungsbereich gegenüberliegenden Kante der Unterseite auf dem Substrat fixiert sind. Dies bedeutet, dass die LED-Chips nicht vollständig auf dem Substrat aufliegen, sondern sich jeweils mit einer Kante der Oberseite des benachbarten LED-Chips und mit der anderen Kante der Unterseite auf dem Substrat abstützen. Diese Konfiguration ist beispielsweise dann von Vorteil, wenn das Substrat die in den LED-Chips entstehende Wärme nicht in genügender Weise abführen kann und ein Kühlmedium, wie z. B. Luft, unter den Unterseiten der LED-Chips hindurchgeführt werden soll.

Es ist aber auch möglich, dass das Substrat eine gestufte Montageseite für die LED-Chips aufweist, wobei jeweils benachbarte LED-Chips mit den jeweils außerhalb der Überlappungsbereiche liegenden Teilen ihrer Unterseiten auf aufeinanderfolgenden Stufen aufliegen. Hierdurch ist es vorteilhaft möglich, die LED-Chips mit einer größtmöglichen Fläche mit dem Substrat mechanisch zu kontaktieren. Hierdurch wird vorteilhaft die direkte Wärmeleitung aus den LED-Chips in das Substrat gefördert. Wenn dieses eine genügende Wärmekapazität und Wärmeleitfähigkeit aufweist, um die in den LED-Chips entstehende Wärme abzuführen, kann hierdurch vorteilhaft die Bauteilzuverlässigkeit der LED-Lichtquelle auch im Dauerbetrieb gewährleistet sein.

Die Stufenhöhe der gestuften Montageseite muss so gewählt sein, dass sich benachbarte Chips miteinander verbinden lassen. Hierbei ist auch die Dicke der erforderlichen Kontaktierung zu berücksichtigen. Diese kann beispielsweise aus einem Lotwerkstoff bestehen, der an der Oberseite oder der Unterseite der LED-Chips vor der Montage bereits angebracht wurde. Für diesen Lotwerkstoff muss ein Spalt zwischen benachbarten Besonders vorteilhaft ist es, wenn die LED-Chips auf der Unterseite mit einer Lotschicht versehen sind. Diese muss zumindest im Überlappungsbereich der Unterseite des betreffenden LED-Chips vorgesehen sein. Sie dient dann der elektrischen Kontaktierung benachbarter LED-Chips, wobei der entsprechende Überlappungsbereich auf der Oberseite des benachbarten LED-Chips an die Unterseite des mit dem Lotwerkstoff vorbereiteten LED-Chips angenähert und verlötet wird.

Besonders vorteilhaft ist es jedoch, wenn der Lotwerkstoff auf der gesamten Fläche der Unterseite des LED-Chips vorgesehen ist. Hierdurch kann vorteilhaft eine besonders einfache Montage der LED-Chips auf dem Substrat erfolgen. Es wird der betreffende LED-Chip nicht nur mit der Oberseite des benachbarten LED-Chips, sondern auch mit dem Substrat verlötet. Da metallische Lotwerkstoffe auch eine gute thermische Leitfähigkeit besitzen, wird hierdurch vorteilhaft eine effiziente Wärmeabführung von den LED-Chips in das Substrat ermöglicht. Selbstverständlich muss in diesem Fall für eine elektrische Isolation dahingehend gesorgt werden, dass die LED-Chips der einzelnen Reihen nicht untereinander kurzgeschlossen werden. Dies kann beispielsweise durch die Verwendung eines elektrisch isolierenden Substrates, wie beispielsweise einer Keramik, sichergestellt werden. Besonders vorteilhaft als Ke ramik ist der Werkstoff AlN, der gleichzeitig eine gute thermische Leitfähigkeit gewährleistet.

Nach einer alternativen Lösung der Erfindung ist vorgesehen, dass das gestufte Substrat eine elektrisch isolierende Oberfläche aufweist und die LED-Chips über eine an die Unterseiten angrenzende, elektrisch leitfähige Zwischenschicht jeweils mit dem Substrat und mit den Oberseiten benachbarter LED-Chips verbunden sind. Die elektrisch isolierende Oberfläche ist von Nöten, wie bereits erwähnt, um einen Kurzschluss benachbarter LED-Chips der verschiedenen Chipreihen zu unterbinden. Neben der Möglichkeit, das Substrat aus einem elektrisch isolierenden Werkstoff herzustellen, besteht selbstverständlich auch die Möglichkeit, das Substrat zumindest in den kurzschlussgefährdeten Bereichen mit einer elektrisch isolierenden Schicht zu versehen, bevor die LED-Cips montiert werden. Die leitfähige Zwischenschicht kann, wie bereits erwähnt, aus einem Lotwerkstoff bestehen, der entweder auf die LED-Chips oder aber auf das Substrat aufgebracht wird. Anschließend wird die Lötverbindung durch Einbringung von Wärme ausgebildet. Als Alternative zu Lotwerkstoffen sind auch Leitkleber zu nennen, mit denen eine Verklebung der LED-Chips möglich ist, wobei die Klebeverbindung gleichzeitig der elektrischen Verschaltung der LED-Chips in Reihe dient.

Weiterhin kann vorteilhaft vorgesehen werden, dass auf den Oberseiten und/oder den Unterseiten der LED-Chips in den Überlappungsbereichen Kontaktflächen angebracht sind, die vom Rand der LED-Chips beanstandet sind. Besonders wichtig ist die Beabstandung vom hinteren Rand der LED-Chips, der sozusagen den betreffenden LED-Chip in Richtung zum benachbarten LED-Chip begrenzt. Durch Vorsehen eines Randes kann vorteilhaft erreicht werden, dass der Verbindungswerkstoff nach Ausbildung der elektrisch leitfähigen Verbindung einen Sicherheitsabstand zum Rand des betreffenden LED-Chips aufweist, wodurch die Sicherheit vor ungewollten Kurzschlüssen steigt. Dies lässt sich beispielsweise bewerkstelligen, wenn die Oberfläche des LED-Chips an sich für beispielsweise einen Lotwerkstoff schwer benetzbar ist. Dieser wird dann auf den Kontaktflächen des LED-Chips verbleiben und dort aufgrund der Oberflächenspannung des Lotwerkstoffes eine kompakte Lötverbindung ausbilden.

Um einen Kurzschluss zwischen benachbarten LED-Chips wirksam zu verhindern, kann es weiterhin vorteilhaft sein, wenn die LED-Chips zumindest an einem Teil der Seitenflächen mit einer elektrischen Isolationsschicht versehen sind. Hierdurch kann erreicht werden, dass Verbindungswerkstoff (beispielsweise Lot), welcher bei Ausbilden der elektrischen Verbindung zwischen zwei benachbarten LED-Chips an den Seitenflächen der LED-Chips haften bleibt, einen Kurzschluss auslöst. Die Ausbildung einer elektrischen Brücke zwischen dem Lot und den Seitenflächen des LED-Chips wird dann nämlich durch die elektrische Isolationsschicht verhindert. Vor allen Dingen die Seitenflächen, die quer zur Ausrichtung der Chipreihe liegen, können vorteilhaft isoliert werden, um die Ausbildung von Kontaktbrücken zu verhindern. Längs zur Ausrichtung der Chipreihe ist eine zuverlässige Isolation benachbarter Chipreihen möglich. Das Material der Isolationsschicht kann bevorzugt ein Oxid oder Lötstopplack sein.

Weiterhin wird die Aufgabe mit einem LED-Chip der eingangs genannten Art gelöst, bei dem die Seitenflächen des LED-Chips zumindest teilweise mit einer elektrisch isolierenden Schicht versehen sind. Der Grund für diese Maßnahme ist vorstehend bereits erläutert worden. Es lässt sich insbesondere vorteilhaft eine höhere Sicherheit gegen die Ausbildung von ungewollten Kurzschlussbrücken innerhalb der Chipreihe erreichen. Hiermit steigt die Bauteilzuverlässigkeit montierter LED-Lichtquellen, die eine Vielzahl der erfindungsgemäßen LED-Chips beinhalten. Gleichzeitig kann ein Ausschuss an montierten, nicht funktionsfähigen LED-Lichtquellen verringert werden, wodurch die Herstellung derselben auch wirtschaftlicher erfolgen kann.

Weitere Einzelheiten der Erfindung werden nachfolgend anhand der Zeichnung beschrieben. Gleiche oder sich entsprechende Zeichnungselemente sind jeweils mit den gleichen Bezugszeichen versehen und werden nur insoweit mehrfach erläutert, wie sich Unterschiede zwischen den einzelnen Figuren ergeben. Es zeigen:
- Figur 1 und 2: Ausführungsbeispiele für den erfindungsgemäßen LED-Chip als räumliche Darstellung,
- Figur 3: ein Ausführungsbeispiel für die erfindungsgemäße LED-Lichtquelle im Schnitt und
- Figur 4: eine Aufsicht auf unterschiedliche Anordnungen von LED-Chips, wie sie in der erfindungsgemäßen LED-Lichtquelle verwirklicht werden können.

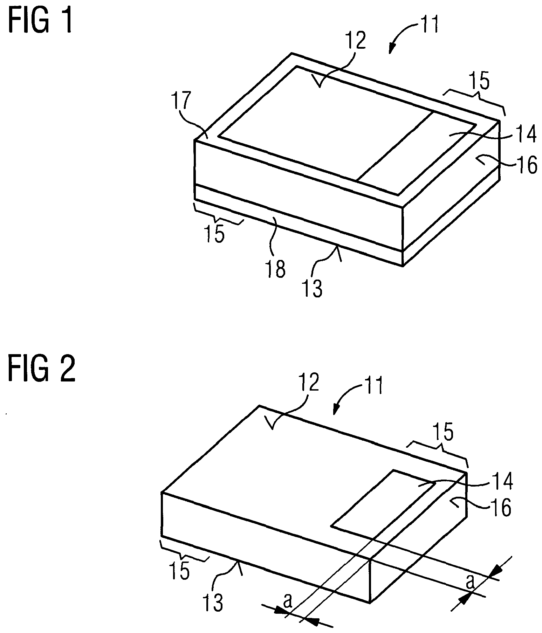

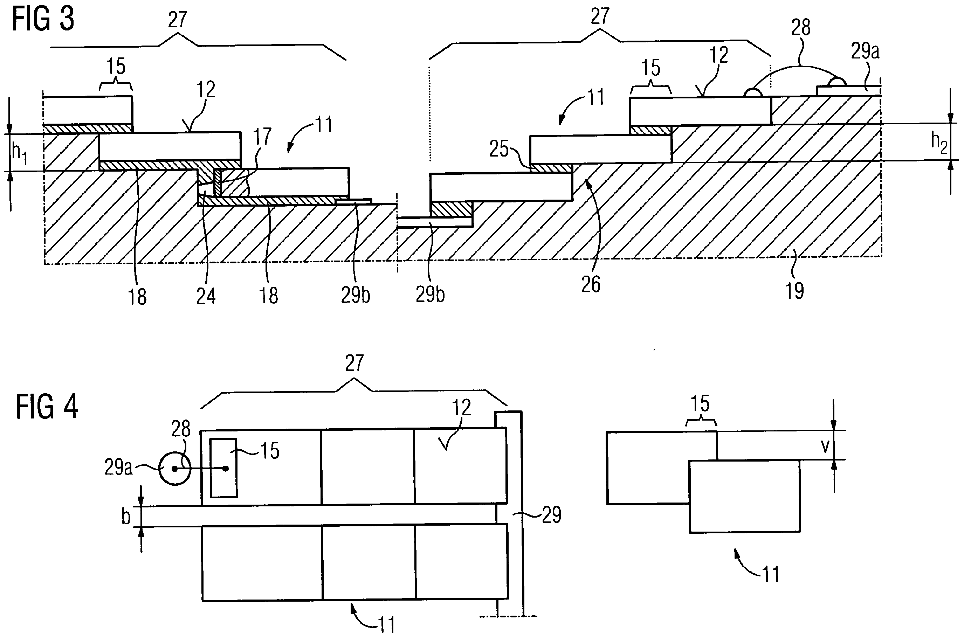

In Figur 1 ist ein LED-Chip 11 dargestellt, der eine Oberseite 12 als Abstrahlfläche und eine Unterseite 13 als Montagefläche (vgl. Figur 3) aufweist. Auf der Oberseite ist ein Kontaktbereich als Kontaktfläche 14 ausgebildet, über den der LED-Chip 11 mit einem nicht dargestellten benachbarten LED-Chip verbunden werden kann. Daher definiert die Kontaktfläche 14 auch einen bei der Montage entstehenden Überlappungsbereich 15 (vgl. auch Figur 3 und 4).

Weiterhin ist der LED-Chip 11 mit verschiedenen Beschichtungen versehen. Seitenflächen 16 des LED-Chips sind mit einer elektrisch isolierenden Schicht 17 versehen, die eine Ausbildung von Kurzschlüssen mit benachbarten LED-Chips verhindert. Außerdem ist die Unterseite 13 mit einer Lotschicht 18 versehen. Mit dieser kann der LED-Chip auf ein nicht dargestelltes Substrat aufgesetzt und durch Wärmeeintrag mit diesem verlötet werden. Gleichzeitig bildet die Lotschicht 18 mit dem benachbarten (nicht dargestellten) LED-Chip im Überlappungsbereich 15 die elektrische Verbindung aus.

Der LED-Chip 11 gemäß Figur 2 ist ähnlich wie derjenige gemäß Figur 1 aufgebaut. Allerdings weist dieser keine elektrische Isolationsschicht auf. Außerdem ist die Kontaktfläche 14 mit Abständen a zu den Seitenflächen 16 ausgebildet, wodurch ein Sicherheitsabstand entsteht, der bei der elektrischen Kontaktierung der Kontaktfläche 14 das Ausbilden von Kurzschlüssen verhindern kann.

In Figur 4 ist ein stufenförmiges Substrat 19 dargestellt. Der stufenförmige Aufbau des Substrates 19 hat den Vorteil, dass die LED-Chips 11 trotz einer Überlappung mit jeweils benachbarten LED-Chips 11 vollständig auf dem Substrat 19 aufliegen können. Hierdurch wird die Wärmeleitung von den LED-Chips 11 in das Substrat 19 unterstützt. Die Anordnung der LED-Chips kann unterschiedlichen Prinzipien folgen, von denen zwei mögliche Prinzipien in Figur 4 (getrennt durch eine Bruchlinie) dargestellt sind.

Links kommen LED-Chips zum Einsatz, die in Aufbau denjenigen in Figur 1 und 3 entsprechen, also eine Lotschicht 18 auf der Unterseite 13 aufweisen. Die Höhe h₁ der Stufen entspricht genau der Höhe der LED-Chips (inklusive der Lotschicht 18, die als Teil des LED-Chips aufgefasst wird). Die Lotschicht 18 hat somit bei den montierten LED-Chips 11 zwei Aufgaben. Die erste Aufgabe besteht in der Herstellung einer elektrischen Verbindung von der jeweiligen Unterseite des LED-Chips zu dem Kontaktbereich (vgl. Figur 1) des jeweils benachbarten LED-Chips 11. Gleichzeitig wird durch die Lotschicht 18 aber auch eine thermisch gut leitende Fixierung des betreffenden LED-Chips 11 auf dem Substrat 19 erreicht.

Durch eine teilweise geschnittene Darstellung lässt sich in Figur 4 auch die Funktion der elektrisch isolierenden Schicht 17 an den Seitenflächen 16 der LED-Chips 11 erkennen. Durch kapillare Kräfte kann nämlich bei Aufschmelzen des Lotwerkstoffes der Lotschicht 18 ein Fließen desselben in den senkrechten Spalt zwischen dem LED-Chip 11 und der durch das Substrat 19 gebildeten Stufe erfolgen. In diesem Fall verhindert die elektrisch isolierende Schicht 17, dass es über die Seitenflächen 16 der LED-Chips zu einem elektrischen Kurzschluss kommt, der die Leuchtfähigkeit der LED-Chips einschränken oder vollständig gefährden könnte.

Rechts ist eine andere Variante der Montage der LED-Chips 11 dargestellt. Diese LED-Chips weisen eine Lötverbindung 25 jeweils nur in den Überlappungsbereichen 15 auf, wodurch die elektrische Reihenschaltung der LED-Chips 11 erfolgt. Allerdings sind die LED-Chips 11 in nicht näher dargestellter Weise mit dem Substrat 19 verklebt. Da die Klebeschicht (nicht dargestellt) dünner ist, als die Lötverbindung 25, müssen die Stufen 26 eine Höhe h₂ aufweisen, die größer ist, als die Höhe der LED-Chips 11. Der so entstehende Spalt zwischen den benachbarten LED-Chips wird durch die Lötverbindung 25 ausgefüllt.

Bei beiden in Figur 4 dargestellten Varianten entstehen Reihen 27 von elektrisch in Reihe geschalteten LED-Chips 11, wobei jeweils der erste und der letzte LED-Chip 11 in der Reihe elektrisch an eine Spannungsversorgung angeschlossen werden muss. Der oberste LED-Chip 11 kann beispielsweise mittels eines Bonddrahtes 28 kontaktiert werden. Hierzu kann auf dem Substrat 11 eine Kontaktfläche 29a vorgesehen sein. Ähnliche Kontaktfläche 29b sind auch für den untersten LED-Chip 11 am Grund der untersten Stufe des Substrates 19 vorgesehen.

In Figur 5 sind verschiedene LED-Chipanordnungen als Aufsicht dargestellt. Beispielsweise können benachbarte Reihen 27 (s. auch Figur 4) angeordnet werden. Zwischen benachbarten Reihen 27 von LED-Chips ist ein Abstand b vorgesehen, der zwecks einer möglichst homogenen Lichtabstrahlung der LED-Lichtquelle möglichst gering ausfallen soll. Für den Fall, dass, wie in Figur 1 dargestellt, die LED-Chips 11 mit einer elektrisch isolierenden Schicht 17 versehen sind, können die benachbarten Reihen 27 von LED-Chips auch Stoß an Stoß auf dem Substrat 19 montiert werden. Weiterhin lässt sich Figur 5 auch entnehmen, dass Reihen von LED-Chips 11 mit einem Versatz v elektrisch kontaktiert werden können. Die Fläche, die durch den Überlappungsbereich 15 zur elektrischen Kontaktierung zur Verfügung steht, wird hierdurch allerdings etwas kleiner, dafür die zur Verfügung stehende Abstrahlfläche für Licht größer.

## Patentansprüche

1. LED-Lichtquelle, aufweisend ein Substrat (19) mit einer Vielzahl von auf diesem fixierten und elektrisch kontaktierten LED-Chips (11),
wobei die LED-Chips (11) überlappend auf dem Substrat (19) fixiert sind und
wobei jeweils sich an Oberseite (12) und Unterseite (13) überlappende LED-Chips (11) in einem so gebildeten Überlappungsbereich (15) unter Ausbildung einer Reihenschaltung elektrisch leitend miteinander verbunden sind, **dadurch gekennzeichnet,**
**dass** das Substrat (19) eine gestufte Montageseite für die LED-Chips aufweist, wobei jeweils benachbarte LED-Chips (11) mit den jeweils außerhalb der Überlappungsbereiche (15) liegenden Teilen ihrer Unterseiten (13) auf aufeinander folgenden Stufen aufliegen, und
**dass** das gestufte Substrat (19) eine elektrisch isolierende Oberfläche aufweist und die LED-Chips (11) über eine an die Unterseiten angrenzende, elektrisch leitfähige Zwischenschicht (18) jeweils mit dem Substrat (19) und mit den Oberseiten (12) benachbarter LED-Chips verbunden sind.

2. LED-Lichtquelle nach Anspruch 1,
**dadurch gekennzeichnet ,dass** die LED-Chips (11) in parallel verlaufenden Reihen angeordnet sind, wobei jeweils benachbarte LED-Chips (11) sich in den Reihen überlappen.

3. LED-Lichtquelle nach Anspruch 2,
**dadurch gekennzeichnet,**
**dass** sich jeweils benachbarte LED-Chips (11) in den Reihen mit einem Versatz v senkrecht zur Ausrichtung der Reihe überlappen.

4. LED-Lichtquelle nach einem der voranstehenden Ansprüche, **dadurch gekennzeichnet,**
**dass** die LED-Chips (11) auf der Unterseite (13) mit einer Lotschicht (18) versehen sind.

5. LED-Lichtquelle nach einem der voranstehenden Ansprüche, **dadurch gekennzeichnet,**
**dass** auf den Oberseiten (12) und/oder den Unterseiten (13) der LED-Chips in den Überlappungsbereichen (15) Kontaktflächen angebracht sind, die vom Rand der LED-Chips beabstandet sind.

6. LED-Lichtquelle nach einem der voranstehenden Ansprüche, **dadurch gekennzeichnet,**
**dass** die LED-Chips zumindest an einem Teil der Seitenflächen mit einer elektrischen isolierenden Schicht (17) versehen sind.

7. LED-Chip mit einer Oberseite (12) und einer Unterseite (13), die beide Kontaktbereiche zur elektrischen Kontaktierung aufweisen, wobei die Seitenflächen (16) des LED-Chips zumindest teilweise mit einer elektrisch isolierenden Schicht (17) versehen sind,
**dadurch gekennzeichnet,**
**dass**
• die Unterseite (13) mit einer Lotschicht (18) versehen ist, die sich über die gesamte Unterseite (13) des LED-Chips erstreckt,
• sich die Kontaktbereiche der Oberseite (12) und der Unterseite (13) in je einem Überlappungsbereich (15) befinden, wobei die Überlappungsbereiche (15) mit je einem benachbarten LED-Chip unter Ausbildung einer Reihenschaltung elektrisch leitend verbindbar sind und
• der LED-Chip mit seinem außerhalb des betreffenden Überlappungsbereiches (15) liegenden Teil seiner Unterseite (13) auf einem Substrat (19) mit einer gestuften Montageseite für LED-Chips montierbar ist.

## Claims

1. LED light source, comprising a substrate (19) with a multiplicity of LED chips (11) fixed and electrically contacted thereon,
wherein the LED chips (11) are fixed in an overlapping fashion on the substrate (19), and
wherein in each case LED chips (11) overlapping at top side (12) and underside (13) are electrically conductively connected to one another in an overlap region (15) thus formed, with formation of a series connection,
**characterized in that in that** the substrate (19) comprises a stepped mounting side for the LED chips, wherein respectively adjacent LED chips (11) bear on successive steps by the parts of the undersides (13) of said LED chips which lie in each case outside the overlap regions (15), and
**in that** the stepped substrate (19) comprises an electrically insulating surface and the LED chips (11) are connected in each case to the substrate (19) and to the top sides (12) of adjacent LED chips via an electrically conductive intermediate layer (18) adjoining the undersides.

2. LED light source according to Claim 1,
**characterized in that**
the LED chips (11) are arranged in series that run parallel, wherein respectively adjacent LED chips (11) overlap in the series.

3. LED light source according to Claim 2,
**characterized**
**in that** respectively adjacent LED chips (11) overlap in the series with an offset v perpendicular to the orientation of the series.

4. LED light source according to any of the preceding claims,
**characterized**
**in that** the LED chips (11) are provided with a solder layer (18) on the underside (13).

5. LED light source according to any of the preceding claims,
**characterized**
**in that** contact pads spaced apart from the edge of the LED chips are fitted on the top sides (12) and/or the undersides (13) of the LED chips in the overlap regions (15).

6. LED light source according to any of the preceding claims,
**characterized**
**in that** the LED chips are provided with an electrically insulating layer (17) at least on a portion of the side surfaces.

7. LED chip having a top side (12) and an underside (13), which both comprise contact regions for electrical contacting, wherein the side surfaces (16) of the LED chip are at least partly provided with an electrically insulating layer (17),
**characterized**
**in that**
• the underside (13) is provided with a solder layer (18) extending over the entire underside (13) of the LED chip,
• the contact regions of the top side (12) and of the underside (13) are situated in a respective overlap region (15), wherein the overlap regions (15) are electrically conductively connectable to a respective adjacent LED chip with formation of a series connection, and
• the LED chip is mountable, by its part of its underside (13) which lies outside the relevant overlap region (15), on a substrate (19) having a stepped mounting side for LED chips.

## Revendications

1. Source de lumière à DEL comportant un substrat (19) ayant une pluralité de puces (11) à DEL qui y sont immobilisées et en contact électrique,
dans laquelle les puces (11) à DEL sont immobilisées à chevauchement sur le substrat (19) et
dans laquelle des puces (11) à DEL à chevauchement, du côté (12) supérieur et du côté (13) inférieur, sont, dans une région (15) de chevauchement ainsi formée, reliées entre elles d'une manière conductrice de l'électricité avec formation d'un circuit série,
**caractérisé**
**en ce que** le substrat (19) a un côté de montage étagé pour les puces à DEL, des puces (11) à DEL voisines s'appliquant par les parties se trouvant à l'extérieur des régions (15) de chevauchement, de leur côté (13) inférieur, sur des étages se succédant et
**en ce que** le substrat (19) étagé a une surface isolante du point de vue électrique et les puces (11) à DEL sont, par une couche (18) intermédiaire conductrice de l'électricité et voisine des côtés inférieurs, reliées respectivement au substrat (19) et aux côtés (12) supérieur de puces à DEL voisines.

2. Source de lumière à DEL suivant la revendication 1, **caractérisé en ce que**
les puces (11) à DEL sont montées en rangées s'étendant parallèlement, des puces (11) à DEL voisines se chevauchant dans les rangées.

3. Source de lumière à DEL suivant la revendication 2, **caractérisé en ce que**
des puces (11) à DEL voisines dans les rangées se chevauchent avec un décalage v perpendiculairement à la direction de la rangée.

4. Source de lumière à DEL suivant l'une des revendications précédentes,
**caractérisé en ce que**
les puces (11) à DEL sont pourvues d'une couche (18) de brasure du côté (13) inférieur.

5. Source de lumière à DEL suivant l'une des revendications précédentes,
**caractérisé en ce que** des surfaces de contact, qui sont à distance du bord des puces à DEL, sont mises sur les côtés (12) supérieurs et/ou les côtés (13) inférieurs des puces à DEL, dans les régions (15) de chevauchement.

6. Source de lumière à DEL suivant l'une des revendications précédentes,
caractérisé en que les puces à DEL sont pourvues d'une couche (17) isolante du point de vue électrique, au moins sur une partie des surfaces latérales.

7. Puces à DEL ayant un côté (12) supérieur et un côté (13) inférieur, qui ont tous deux des régions de contact pour la mise en contact électrique, les surfaces (16) latérales de la puce à DEL étant pourvues, au moins en partie, d'une couche (17) isolante du point de vue électrique,
**caractérisé**
**en ce que**
• le côté (13) inférieur est pourvu d'une couche (18) de brasure, qui s'étend sur tout le côté (13) inférieur de la puce à DEL,
• les régions de contact du côté (12) supérieur et du côté (13) inférieur se trouvent dans respectivement une région (15) de chevauchement, les régions (15) de chevauchement pouvant être reliées d'une manière conductrice de l'électricité avec formation d'un circuit série à respectivement une puce à DEL voisine et
• la puce à DEL peut, par sa partie, se trouvant à l'extérieur de la région (15) de chevauchement concernée, de son côté (13) inférieur, être montée sur un substrat (19) ayant un côté de montage étagé pour des puces à DEL.
